# EUROPEAN PATENT SPECIFICATION

(11) **EP 1 510 929 B1**
(45) Date of publication and mention of the grant of the patent: **23.08.2006**
(21) Application number: 03019788.3
(22) Date of filing: 29.08.2003
(51) Int. Cl.: G06F 13/40, H03K 17/80

(54) **Circuit system and method for coupling a circuit module to or for decoupling same from a main bus**
Schaltungssystem und Methode zum Verbinden eines Moduls zu, oder dessen Entkopplung von, einem Hauptbus
Circuit et méthode pour coupler ou découpler un module d'un bus principal

(43) Date of publication of application: 02.03.2005
(73) Proprietor: Infineon Technologies AG, 81669 München (DE)
(72) Inventor: Kuzmenka, Maksim, 81829 München (DE)
(74) Representative: Schoppe, Fritz

(56) References cited:
- US-A- 2 937 285
- US-A- 3 289 185
- US-A- 3 351 911

## Description

The present invention relates to a circuit system comprising a circuit module to be coupled to or to be decoupled from a main bus. In particular, the circuit system can be a memory system, the circuit module can be a memory module and the main bus can be a memory bus.

In order to read data from a circuit module or to write data to the memory module, a main bus can be provided for accessing the memory module. Usually, the circuit module is connected to the main bus via a sub-bus. Generally, the memory bus and the sub-bus are formed by a number of transmission lines. The conventional structures of memory systems or memory sub-systems use a plurality of memory modules each of which being connected to the memory bus by a respective main bus. In such memory systems containing more than one memory module, only a memory module or bank is active at a time.

In multi-drop buses (for example a data bus of a computer memory), data rate is often limited by a large number of loads, for example receiver or transmitter input capacitances connected to the bus. Thus, parasitic parameters of non-active modules cause signal distortions and restrict the overall bandwidth of the bus and/or the number of connectable memory modules. The parasitic parameters include the input capacitances of the non-active modules and reflections caused by non-terminated transmission line stubs due to the non-active modules. These stubs cause impedance violations and, therefore, reflections distorting signal shapes. Thus, the data rate in the data bus of such memory systems including more than one circuit module is restricted due to the influence of the parasitic parameters of the non-active modules.

So far, different techniques were used for disconnecting non-active devices from the data bus or to reduce the number of devices connected to the bus. A first approach was to make use of two to four separate data busses, i.e. drivers, to keep the number of loads per driver in an acceptable range. This approach is , however, quite expensive. Thus, in existing designs, the above-mentioned problems are solved by using switches, e.g. MOSFET transistors or diodes, are used which disconnect non-active devices from the bus. This approach, however, suffers from the parasitic influence caused by the characteristics of the switches. In addition, transient impulses generated by switching may occur and couple to the memory bus, so that further signal disturbances may result. In order to prevent such a scenario, complex circuitry preventing transients is possible. This concept suffers from increased system's complexity and increased costs.

US 3, 351,911 A discloses an interfacing system comprising signal transmitting magnetic cores arranged in a pre-wired electrical conductor selection bus which is selectively operated by the computer. The interfacing system comprises digital input terminals connected to the cores on the selection bus, wherein output signals from the cores are applied to a digital register for subsequent transfer on a line to a computer. The cores are switched in a conventional manner between stable states at opposite ends of the hysteresis loop.

US 2,937,285 A discloses a saturable switch comprising a magnetic bar capable of acting as a transformer core and carrying three sets of windings, wherein a first winding is coupled to a source of alternating current and functions as a driving winding. A second winding functions as a control winding. A further winding functions in the same way as the secondary winding of a transformer in order to detect changes in the flux of the core and to produce an output, which depends on flux changes.

It is the object of the present invention to provide an efficient concept for coupling a circuit module to or for decoupling same from a main bus.

This object is achieved by a Circuit system according to claim 1 or by a method for coupling a circuit module to or for decoupling same from a main bus according to claim 12.

The present invention is based on the finding that a circuit module can be coupled to a main bus or decoupled from same using magnetic switches. In particular, it has been found, that non-linear dependence of an inductance from a current across a magnetic switch including a ferromagnetic material may be utilized for coupling or decoupling purposes.

It is an advantage of the present invention, that memory modules can be coupled to a main bus or decoupled from same cost-efficiently, since only one additional element, for example a throttle as a magnetic switch, may be applied for switching. It is another advantage of the present invention that the inventive concept prevents occurring of transient pulses while switching without additional costs, since the curve describing the dependence of the conductance from the currents across the magnetic switch always is differentiable.

It is a further advantage of the present invention that a complexity of an additional circuitry is low since coupling and decoupling procedures are substantially controlled by a current across the switch.

It is a further advantage of the present invention, that a DC drop or a voltage shift across the switch, both occurring in the case of diode switches, does not occur. Furthermore, no significant capacitance is added, like it is a case, when MOSFET switches are used. Additionally, the switching state is self-controllable, so that the switch disconnects a signal as the corresponding device changes its state towards a non-conductive (Z) state. The inventive switches can be also integrated into the connectors or boards.

Further embodiments of the present invention are described in detail with respect to the following figures, in which:
- Fig. 1: shows a schematic diagram of a circuit system in accordance with a first embodiment of the present invention;
- Fig. 2a: shows an induction curve depending on a magnetic field strength;
- Fig. 2b: shows an induction curve depending on a current across the magnetic switch;
- Fig. 3a: shows a first embodiment of a magnetic switch in accordance with the present invention;
- Fig. 3b: shows a further embodiment of a magnetic switch in accordance with the present invention;
- Fig. 3c: shows a further embodiment of a magnetic switch in accordance with the present invention;
- Fig. 4: shows a further embodiment of the inventive circuit system; and
- Fig. 5: shows a further embodiment of the inventive circuit system.

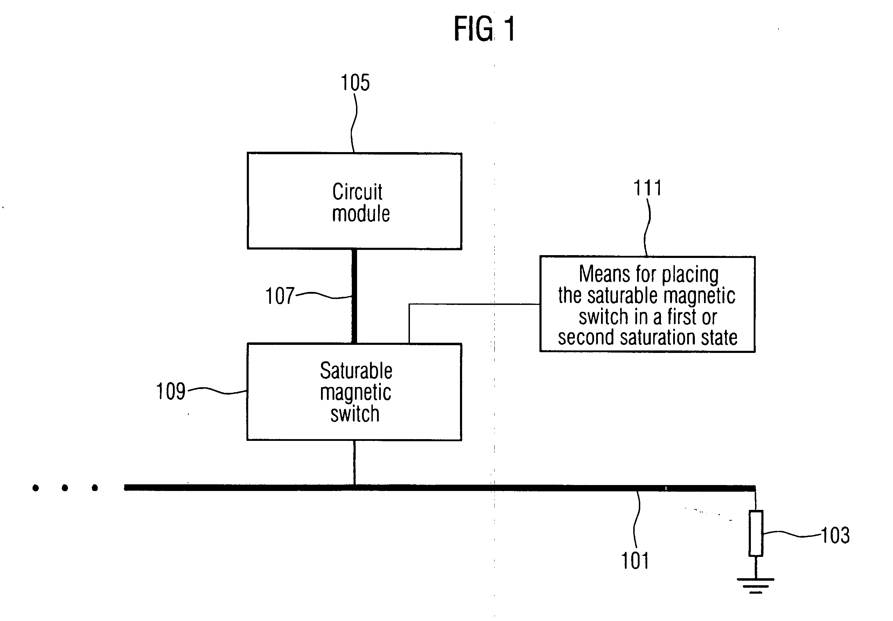

The circuit system shown in Fig. 1 comprises a main bus 101 terminated by a resistor 103 connected between the main bus 101 and ground. The circuit system shown in Fig. 1 further comprises a circuit module 105 connected to a sub-bus 107, which may be a transmission line. The sub-bus 107 is coupled by a saturable magnetic switch 109 to the main bus 101. Furthermore, means 111 for placing the saturable magnetic switch in a first or second saturation state is coupled to the saturable magnetic switch 109.

In the following, the functionality of the circuit system shown in Fig. 1 will be discussed.

The main bus 101 can be a data bus of a computer memory or any other bus being operative to connect a plurality of peripheral devices with each other. In order to couple the circuit module 105 to the main bus 101, the saturable magnetic switch 109 is coupled substantially between the circuit module 105 and the main bus 101. To be more specific, the saturable magnetic switch 109 is connected between the sub-bus and the main bus 101. It is to be noted that a further portion of the sub-bus can be provided between the saturable magnetic switch 109 and the main bus 101.

The saturable magnetic switch 109 has a first inductance in a first saturation state and a second inductance in a second saturation state, wherein the first inductance is lower than the second inductance. Since the inductance of the saturable magnetic switch 109 substantially determines its AC impedance (AC=alternating current), the circuit module 105 is coupled to the main bus 101, when the inductance of the saturable magnetic switch 109 (and hence its impedance) approaches zero. Accordingly, the circuit module 105 is decoupled from the main bus 101 when the inductance of the saturable magnetic switch 109 approaches infinity.

In practical systems, however, the inductance of the saturable magnetic switch 109 may neither approach zero nor infinity. Nevertheless, if the first inductance is substantially lower than the second inductance (for example by a factor of ten), then the circuit module 105 may be considered as being coupled to the main bus 101. In contrast, circuit module 105 may be considered as being decoupled to the main bus 101, when the saturable magnetic switch 109 has the second inductance.

In order to place the magnetic switch 109 in the first saturation state for coupling the sub-bus 107 (and hence the circuit module 105) to the main bus 101, or for placing the saturable magnetic switch 109 in the second saturation state for decoupling the sub-bus 107 (and hence the circuit module 105) from the main bus 101, the means 111 for placing the saturable magnetic switch in a first or second saturation state is used.

Preferably, the saturable magnetic switch 109 comprises a conductor and a ferromagnetic material which can be saturable by a DC current. In this case, the means 111 for placing is operative to generate a DC current, for example a first DC current, through the conductor for saturating the ferromagnetic material, in order to bring the magnetic switch 109 in the first saturation state being characterized by the low impedance for coupling the circuit module 105 to the main bus 101.

For decoupling the circuit module 105 from the main bus 101, the means 111 for placing generates a second DC current through the conductor, the second DC current being lower than the first DC current and, hence, saturating the ferromagnetic material to a less extent, so that the magnetic switch 109 is brought in the second saturation state being characterized by a higher inductance. Preferably, the value of the second DC current equals zero. The second DC current may, however, have a value being different from zero (for example 1µA) so that the ferromagnetic material comprised by the saturable magnetic switch 109 is always saturated at some extent. The DC current used flows through the saturable magnetic switch 109 via the termination resistor 103 to ground.

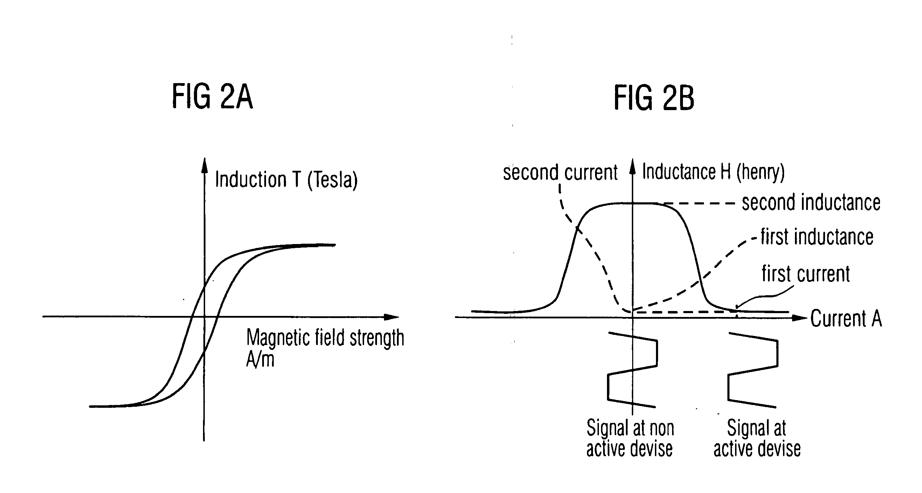

In order to explain the physical effects exploited for magnetic switching, reference is made to Figs. 2a and 2b.

Fig. 2a shows a graph of an induction T of the ferromagnetic material versus the magnetic field strength. It can be seen, that the induction does not follow the same curve, i.e. shows a hysteresis, when increasing and decreasing the magnetic field strength due to the magnetization of a ferromagnetic material comprised by the inventive saturable magnetic switch 109.

Fig. 2b shows a non-linear dependence of the inductance of an inventive magnetic switch including a ferromagnetic material from a current through the magnetic switch i.e. the conductor wherein a principle dependence is shown. For example, if a first current depicted in Fig. 2b is applied to the conductor, then the inductance of the magnetic switch is lower than a second inductance of the magnetic switch when a second current is applied to the conductor, the second current having a value which is lower than the value of the first current. If the value of the second current is equal to zero, then the second inductance approaches its maximum value which results in an increased (high frequency) impedance.

The inventive magnetic switch is based on the property of ferromagnetic materials to reduce a magnetic conductivity after a certain level (depending on the ferromagnetic material used) of the magnetization. As discussed above, the inductance and subsequently the high frequency impedance of the magnetic switch, which can be a throttle with a ferromagnetic curve, has a non-linear dependence on the current across the switch. The inductance (and hence the AC impedance) of the saturated magnetic switch can be M times lower than the inductance of non-saturated magnetic switch, wherein M denotes a magnetic conductivity across the ferromagnetic curve material. For existing high frequency ferromagnetic materials, M can be up to 100.

As depicted in Fig. 2b, the inductance of a magnetic switch decreases with increasing current across the switch. Since a low inductance corresponds to a low-impedance of the magnetic switch, a circuit module (active device) is coupled to the main bus. In this case, the circuit module is considered as being an active device, so that the signal at the active device depicted in Fig. 2b may be transmitted from or to the circuit module. Accordingly, with decreasing current through the switch, the switch' inductance increases. For example, if the value of the second current through the switch is equal to zero, then the switch inductance, and hence its impedance, approaches maximum. Hence, a signal of non-active device depicted in Fig. 2b experiences a higher high frequency impedance when compared to the active case, so that the circuit module may be considered as being de-coupled from the main bus (non-active device).

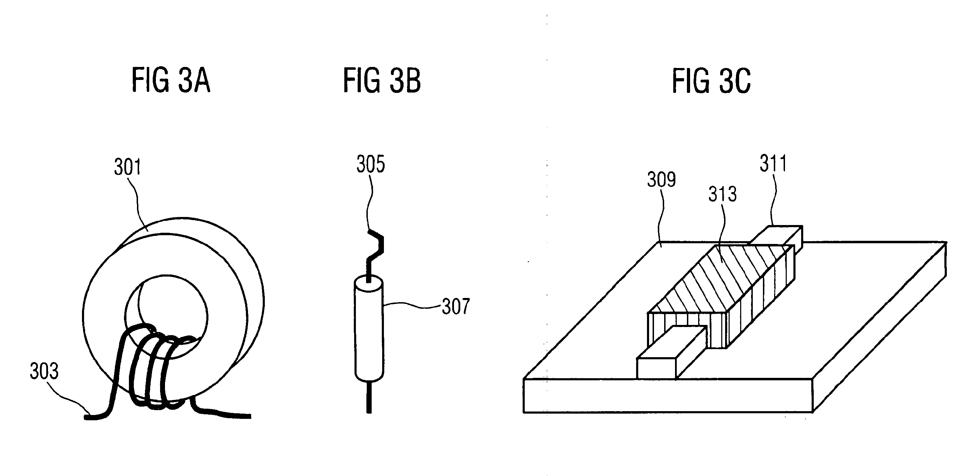

Figs. 3a, 3b and 3c show preferred embodiments of the magnetic switch in accordance with the present invention.

Fig. 3a shows a ferromagnetic toroidal core 301 serving as ferromagnetic material. The magnetic switch of Fig. 3a further comprises a conductor 303 having a plurality of windings around the ferromagnetic core 301.

Additionally, also a secondary winding can be used for generation of a magnetic field for changing a magnetic switch state.

The magnetic switch shown in Fig. 3a is characterized by a high inductance in a non-saturated state and a low inductance in a saturated state, so that the characteristics of such a ferromagnetic switch significantly differ from each other in the saturated and in the non-saturated state.

The magnetic switch shown in Fig. 3b comprises a conductor 305 enclosed by a ferromagnetic material 307. Generally, it is sufficient that the ferromagnetic material 307 encloses at least a portion of the conductor 305 in order to achieve a required saturation state of the ferromagnetic material for switching purposes.

The magnetic switch of in Fig. 3b has the advantage, that the ferromagnetic material is arranged on the wire (pipe on wire) and can be integrated into the connector connecting the circuit module to the main bus. The arrangement of Fig. 3b is further characterized by low parasitics and a lower cross capacitance, when compared to the magnetic switch shown in Fig. 3a. Furthermore, the magnetic switch shown in Fig. 3b can be manufactured at lower price than the toroidal magnetic switch shown in Fig. 3a.

The magnetic switch shown in Fig. 3c comprises a substrate 309, on which a conductor 311 is formed, wherein the conductor 311 is a strip line. A portion of the conductor 311 is surrounded by a ferromagnetic material 313, wherein the ferromagnetic material may be shell-shaped. However, it may be sufficient for switching purposes, when the ferromagnetic material encloses a smaller portion of the conductor 311. The ferromagnetic material 311 may also be formed as a shell for a printed circuit board (PCB) trace. An advantage of the arrangement shown in Fig. 3c is a controlled trace impedance and low parasitics.

In the magnetic switches used according to the invention, for example cobalt may be used as a ferromagnetic material.

The advantages of the magnetic switch implemented in planar technology as depicted in Fig. 3c achieved in accordance with the present invention, especially the cost efficiency, could only be achieved in case of data rates of several gigabits per second. Otherwise, the dimensions and hence the costs of the magnetic switches could be very high.

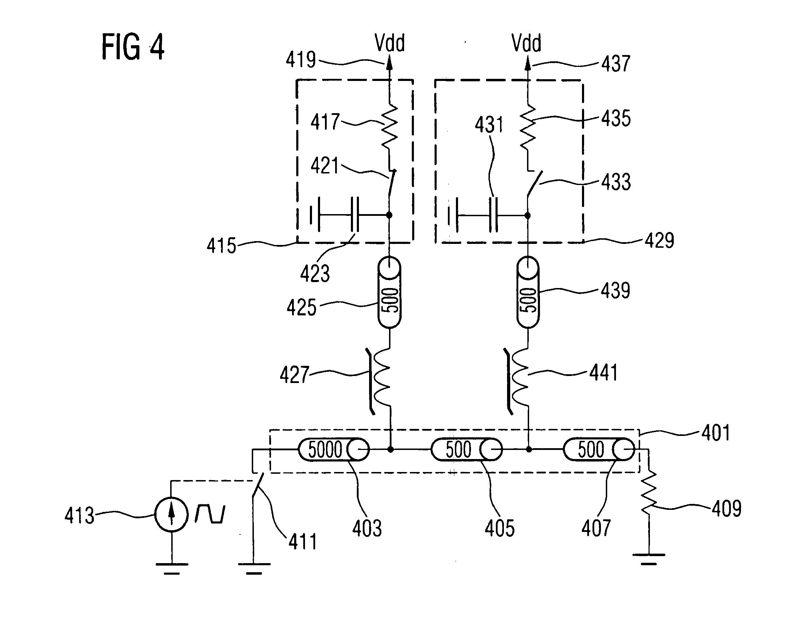

Fig. 4 shows a further embodiment of a circuit system in accordance with the present invention.

The circuit system shown in Fig. 4 comprises a main bus 401 being characterized by a first trace 403 having a length of 5,000 mil, a second trace 405 having a trace length of 500 mil and a third trace 407 having a trace length of 500 mil, wherein 1 mil = 0.0254 millimetres. The first trace 403, second trace 405 and third trace 407 are connected in series. It should be noted, that the trace lengths indicated are chosen by way of example only.

The main bus 401 is terminated by a termination resistor 409 connected between the third trace 407 and ground. At its opposite end, the main bus 401 is coupled via a (controllable) switch 411 to ground. The switch 411 may be for example a transistor.

The switch 411 is controlled by a controller 413 connected between a control input of the switch 411 and ground.

The circuit system shown in Fig. 4 further comprises a circuit module 415. The circuit module 415 is characterized by a termination resistor 417 connected in series between a connecting pin 419 and a switch 421. The switch 421 is coupled between the termination resistor 417 and a capacitance 423 terminated to ground. The capacitance 423 represents an input capacitance of the circuit module 415.

The circuit module 415 is connected to a sub-bus 425 via the switch 421. The sub-bus 425 is coupled to the main bus 401 by a magnetic switch 427, so that the termination resistor 417, the sub-bus 425 and the magnetic switch 427 are connected in series. The so resulting memory slot 1 (slot 1) is coupled to the main bus 401 between the first trace 403 and the second trace 405. The sub-bus 425 has, for example, a length of 500 mil.

The circuit system shown in Fig. 4 shows also a second memory slot (slot 2) coupled to the main bus 401 at a point between the second trace 405 and the third trace 407. The second memory slot has an identical structure as the first memory slot discussed above. To be more specific, the second memory slot comprises a circuit module 429 being characterized by a capacitance 431 coupled to a switch 433 and a termination resistor 435 connected in series to the switch 433, and ground. The termination resistor 435 is coupled between the switch and a connecting pin 437.

The circuit module 429 is coupled by a sub-bus 439 and a magnetic switch 441 connected in series to the sub-bus 439 to the main bus 401. The sub-bus 439 has, by the way of example, a length of 500 mil.

In following, the functionality of the circuit system shown in Fig. 4 will be explained.

Fig. 4 demonstrates an embodiment of a write operation wherein the memory 415, which represents an active device, may be accessed for writing. For this purpose, the switch 421 is closed and a DC voltage, for example vdd, is applied to the connecting pin 419. A resulting DC current flows through the circuit module, the sub-bus 425 (stub) across the magnetic switch 427 via the terminating resistor 409 to ground. The magnetic switch 427 is for example a throttle comprising a ferromagnetic material. The DC current saturates the ferromagnetic material, and hence the magnetic switch, so that an inductance of the magnetic switch 427 decreases. Since the DC current flowing through the resistors 417 and 419 saturates the ferromagnetic core of the throttle 427, the inductance of the throttle 427 may be considered as being negligibly low, so that the circuit module 415 can be accessed.

For writing data (information) into the circuit module 415, the controller 413 controls the switching position 411 in accordance with the information to be written into the memory to thus drive the main bus 401.

The switch 433 slot 2 which is not active is open. Thus, the sub-bus 439 and the input capacitance would represent a non-terminated stub line. In order to address the disturbing effects of such a stub line, according to the invention, the magnetic switch 441 is provided. To be more specific, the sub-bus 439 and the capacitance 431 are isolated from the motherboard's main bus 401 (data bus), because there is no current flow through the inductor of the throttle 441. Since the ferromagnetic material of the throttle 441 is not saturated, the throttle 441 has a high inductance, and hence, an AC high impedance.

The memory controller 413 shown in Fig. 4 is operative to supply an information signal to the main bus for storing information in the respective circuit module 415 and/or 429, when the respective magnetic switches 427 and/or 441 are in a first saturation state characterized by a low AC impedance.

In the embodiment shown in Fig. 4, the means for placing the magnetic switch in the first or second saturation state is formed by a DC current source comprising the (on die) resistors 417, 435 coupled between the switches 421 and 433 and the connecting pins. Hence, the means for placing is integrated in the respective circuit module 415 and 429 and the respective switch 421, 433 is coupled to the conductor of the respective throttle 427 and 441 by the respective sub-bus 425 and 439.

Alternatively, the means for placing may be arranged outside of the respective circuit module 415 and 429. In this case, the means for placing may comprise, external to the memory module, a DC current source and a switch for connecting or separating the DC current source to the respective magnetic switch.

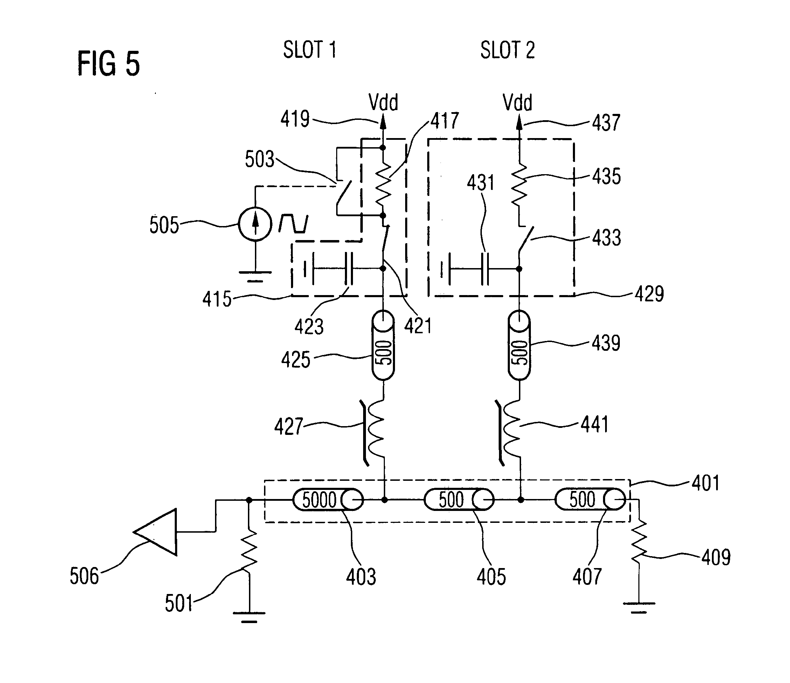

The embodiment shown in Fig. 5 demonstrates a read operation from the circuit module 415. In the read operation, the main bus 401 is disconnected from the controller 413 (not shown in Fig. 5). Furthermore, the main bus 401 is terminated by a termination resistor 501 to ground at the end opposite to the end terminated by the resistor 409.

In parallel to the termination resistor 417 of the circuit module 415, a switch 503 is connected. The switch 503 is controlled by a controller 505.

In following, the functionality of the circuit system shown in Fig. 5 will be explained.

Since the switch 421 is closed, a DC current saturates the ferromagnetic material of the throttle 427. Hence, the circuit module 415 is coupled to the main bus.

The controller 505 opens and closes the switch 503 for bridging and not-bridging the resistor 417, so that the current through the magnetic switch 427 is modulated in accordance with the information stored in the circuit module 415. Since the ferromagnetic material of the throttle 427 is saturated, the DC current is modulated over the saturated throttle 427. The data stored in the module 415 can be read out at the termination resistor 501, as indicated by the arrow 506.

At this point it is to be noted, that the terminator resistor 501 is only an optional resistor. Furthermore, the circuit modules 415 and 429 can be integrated in a silicon chip. Additionally, all switches except for the magnetic switches, may be formed by transistors and preferably field effect transistors.

In general, the active device on a main bus generates a DC current representing a saturation level across the corresponding switch and enables to drive data by changing a current level above the saturation level. For a non-active device, the input capacitance of the non-active device and the stub line (stub trace) formed by the respective sub-bus are isolated from the bus by the high impedance of the magnetic switch to which the DC current is not applied.

The bus may consist of a plurality of lines, wherein a respective magnetic switch can be provided for each of the lines or a magnetic switch can be provided for a plurality of lines, respectively.

## Claims

1. Circuit system, comprising:
a main bus (101; 401);
a circuit module (105; 415, 429) connected to a sub-bus (107; 425, 439); **characterized by**
a saturable magnetic switch (109; 427, 441) comprising a conductor (303; 305, 311) connected between the sub-bus (107; 425, 439) and the main bus (101; 409) and a ferromagnetic material (301, 307, 313) saturable by a DC-current through the conductor (303, 305, 311), wherein the saturable magnetic switch (109; 427, 441) has a first inductance in a first saturation state and a second inductance in a second saturation state, the first inductance being lower than the second inductance;
means (111) for placing the saturable magnetic switch (109; 427, 441) in one of the first saturation state for coupling the sub-bus (107; 425, 439) to the main bus (101; 409) and the second saturation state for decoupling the sub-bus (107; 425, 439) from the main bus (101; 409).

2. Circuit system in accordance with claim 1, wherein the main bus (101; 401) is a memory bus and wherein the circuit module is a memory module.

3. Circuit system in accordance with claim 1, wherein the ferromagnetic material (301, 307, 311) is a ferromagnetic toroidal core (301) and wherein the conductor (303) comprises a plurality of windings around the ferromagnetic toroidal core (301).

4. Circuit system in accordance with claim 1, wherein the ferromagnetic material (307, 313) encloses at least a portion of the conductor (305, 311).

5. Circuit system in accordance with claim 1, wherein the conductor (311) is a strip line formed on a substrate (309), and wherein the ferromagnetic material (313) encloses at least a portion of the strip line (311).

6. Circuit system in accordance with any one of the claims 1 to 5, wherein the means (111) is operative to generate a first DC current through the conductor (303, 305, 311) for saturating the ferromagnetic material (301, 307, 313), to bring the magnetic switch (109; 427, 441) in the first saturation state.

7. Circuit system in accordance with claim 6, wherein the means (111) for placing comprises a DC current source connected to the conductors (303, 305, 311) by a switch (421, 433) having a first switching state and a second switching state, and wherein the means (111) is operative to bring the switch (421, 433) in the first switching state for connecting the conductors (303, 305, 311) to the DC current source for generating the first DC current or to bring the switch in the second switching state for disconnecting the connector (303, 305, 311) from the DC current source.

8. Circuit system in accordance with claim 7, wherein the means (111) for placing is integrated in the circuit module (415, 429), so that the switch (421, 433) is coupled to the conductor (303, 305, 311) by the sub-bus (425, 439).

9. Circuit system in accordance with claim 8, wherein the DC current source comprises a termination resistor (417, 435) coupled between the switch (412, 433) and a connecting pin (419, 437), and wherein the connecting pin (419, 437) is adapted for being is applied by a DC voltage for generating a DC current.

10. Circuit system in accordance with any one of the claims 1 to 9, wherein the circuit system further comprises a memory controller (413) being operative to supply an information signal to the main bus (101; 401) for storing information in the circuit module (105; 415, 429) when the saturable magnetic switch (109; 427, 441) is in the first saturation state.

11. Circuit system in accordance with claims 9 or 10, wherein the circuit module (105; 415, 429) comprises a further switch (503) coupled parallel to the resistor (417), the switch being operative to bridge or not to bridge the resistor (417) for modulating a current to the main bus (401) in accordance with an information stored in the circuit module (415).

12. Method for coupling a circuit module to or for decoupling same from a main bus (101; 401), the circuit module being coupled to a sub-bus, the sub-bus being coupled to the main bus by a saturable magnetic switch (109), the saturable magnetic switch (109) comprising a conductor connected between the sub-bus and the main bus and a ferromagnetic material saturable by a DC current through the conductor, the magnetic switch having a first inductance in a first saturation state and a second inductance in a second saturation state, the first inductance being lower than the second inductance, the method comprising the steps of:
placing the saturable magnetic switch (109) in the first saturation state for coupling the sub-bus (107) to the main bus (101), or
placing the saturable magnetic switch (109) in the second saturation state for decoupling the sub-bus (107) from the main bus (101; 401).

## Patentansprüche

1. Schaltungssystem, das folgende Merkmale aufweist:
einen Hauptbus (101; 401);
ein Schaltungsmodul (105; 415, 429), das mit einem Unterbus (107; 425, 439) verbunden ist; **gekennzeichnet durch**
einen sättigungsfähigen Magnetschalter (109; 427, 441), der einen Leiter (303; 305, 311), der zwischen den Unterbus (107; 425, 429) und den Hauptbus (101; 409) geschaltet ist, und ein ferromagnetisches Material (301, 307, 313), das **durch** einen durch den Leiter (303, 305, 311) fließenden Gleichstrom sättigbar ist, umfasst, wobei der sättigbare Magnetschalter (109; 427, 441) in einem ersten Sättigungszustand eine erste Induktanz und in einem zweiten Sättigungszustand eine zweite Induktanz aufweist, wobei die erste Induktanz geringer ist als die zweite Induktanz;
eine Einrichtung (111) zum Versetzen des sättigungsfähigen Magnetschalters (109; 427, 441) entweder in den ersten Sättigungszustand zum Koppeln des Unterbusses (107; 425, 439) mit dem Hauptbus (101; 409) oder in den zweiten Sättigungszustand zum Entkoppeln des Unterbusses (107; 425, 439) von dem Hauptbus (101; 409).

2. Schaltungssystem gemäß Anspruch 1, bei dem der Hauptbus (101; 401) ein Speicherbus ist und bei dem das Schaltungsmodul ein Speichermodul ist.

3. Schaltungssystem gemäß Anspruch 1, bei dem das ferromagnetische Material (301, 307, 311) ein ferromagnetischer Ringkern (301) ist und bei dem der Leiter (303) eine Mehrzahl von Wicklungen um den ferromagnetischen Ringkern (301) herum umfasst.

4. Schaltungssystem gemäß Anspruch 1, bei dem das ferromagnetische Material (307, 313) zumindest einen Teil des Leiters (305, 311) umschließt.

5. Schaltungssystem gemäß Anspruch 1, bei dem der Leiter (311) eine auf einem Substrat (309) gebildete Streifenleitung ist und bei dem das ferromagnetische Material (313) zumindest einen Teil der Streifenleitung (311) umschließt.

6. Schaltungssystem gemäß einem der Ansprüche 1 bis 5, bei dem die Einrichtung (111) dahin gehend wirksam ist, einen ersten Gleichstrom durch den Leiter (303, 305, 311) zum Sättigen des ferromagnetischen Materials (301, 307, 313) zu erzeugen, um den Magnetschalter (109; 427, 441) in den ersten Sättigungszustand zu bringen.

7. Schaltungssystem gemäß Anspruch 6, bei dem die Einrichtung (111) zum Versetzen eine Gleichstromquelle umfasst, die mittels eines Schalters (421, 433), der einen ersten Schaltzustand und einen zweiten Schaltzustand aufweist, mit den Leitern (303, 305, 311) verbunden ist und bei dem die Einrichtung (111) dahin gehend wirksam ist, den Schalter (421, 433) in den ersten Schaltzustand zu bringen, um die Leiter (303, 305, 311) mit der Gleichstromquelle zu verbinden, um den ersten Gleichstrom zu erzeugen oder dahin gehend wirksam ist, den Schalter in den zweiten Schaltzustand zu bringen, um den Verbinder (303, 305, 311) von der Gleichstromquelle zu trennen.

8. Schaltungssystem gemäß Anspruch 7, bei dem die Einrichtung (111) zum Versetzen in das Schaltungsmodul (415, 429) integriert ist, so dass der Schalter (421, 433) mittels des Unterbusses (425, 439) mit dem Leiter (303, 305, 311) gekoppelt ist.

9. Schaltungssystem gemäß Anspruch 8, bei dem die Gleichstromquelle einen Abschlusswiderstand (417, 435) umfasst, der zwischen den Schalter (412, 433) und einen Verbindungsstift (419, 437) gekoppelt ist und bei dem der Verbindungsstift (419, 437) dahin gehend angepasst ist, durch eine Gleichspannung zum Erzeugen eines Gleichstroms angelegt zu werden.

10. Schaltungssystem gemäß einem der Ansprüche 1 bis 9, wobei das Schaltungssystem ferner eine Speichersteuerung (413) umfasst, die dahin gehend wirksam ist, ein Informationssignal zum Speichern von Informationen in dem Schaltungsmodul (105; 415, 429) an den Hauptbus (101; 401) zu liefern, wenn sich der sättigungsfähige Magnetschalter (109; 427, 441) in dem ersten Sättigungszustand befindet.

11. Schaltungssystem gemäß Anspruch 9 oder 10, bei dem das Schaltungsmodul (105; 415, 429) einen weiteren Schalter (503) umfasst, der parallel mit dem Widerstand (417) gekoppelt ist, wobei der Schalter dahin gehend wirksam ist, den Widerstand (417) zu überbrücken oder nicht zu überbrücken, um einen Strom zu dem Hauptbus (401) gemäß einer in dem Schaltungsmodul (415) gespeicherten Information zu modulieren.

12. Verfahren zum Koppeln eines Schaltungsmoduls mit einem Hauptbus (101; 401) oder zum Entkoppeln desselben von einem Hauptbus (101; 401), wobei das Schaltungsmodul mit einem Unterbus gekoppelt ist, wobei der Unterbus anhand eines sättigungsfähigen Magnetschalters (109) mit dem Hauptbus gekoppelt ist, wobei der sättigungsfähige Magnetschalter (109) einen zwischen den Unterbus und den Hauptbus geschalteten Leiter und ein anhand eines durch den Leiter fließenden Gleichstroms sättigungsfähiges Material umfasst, wobei der Magnetschalter in einem ersten Sättigungszustand eine erste Induktanz aufweist und in einem zweiten Sättigungszustand eine zweite Induktanz aufweist, wobei die erste Induktanz geringer ist als die zweite Induktanz, wobei das Verfahren folgende Schritte umfasst:
Versetzen des sättigungsfähigen Magnetschalters (109) in den ersten Sättigungszustand zum Koppeln des Unterbusses (107) mit dem Hauptbus (101), oder
Versetzen des sättigungsfähigen Magnetschalters (109) in den zweiten Sättigungszustand zum Entkoppeln des Unterbusses (107) von dem Hauptbus (101; 401).

## Revendications

1. Système de circuit, comprenant :
un bus principal (101; 401) ;
un module de circuit (105 ; 415, 429) connecté à un sous-bus (107 ; 425, 439) ; **caractérisé par**
un interrupteur magnétique saturable (109 ; 427, 441) comprenant un conducteur (303 ; 305, 311) connecté entre le sous-bus (107 ; 425, 439) et le bus principal (101 ; 409) et un matériau ferromagnétique (301, 307, 313) saturable par un courant DC passant dans le conducteur (303, 305, 311), dans lequel l'interrupteur magnétique saturable (109 ; 427, 441) présente une première inductance dans un premier état de saturation et une deuxième inductance dans un deuxième état de saturation, la première inductance étant plus basse que la deuxième inductance ;
un moyen (111) destiné à placer l'interrupteur magnétique saturable (109 ; 427, 441) soit dans le premier état de saturation, pour coupler le sous-bus (107 ; 425, 439) au bus principal (101 ; 409), soit dans le deuxième état de saturation, pour découpler le sous-bus (107 ; 425, 439) du bus principal (101 ; 409).

2. Système de circuit selon la revendication 1, dans lequel le bus principal (101 ; 401) est un bus de mémoire et dans lequel le module de circuit est un module de mémoire.

3. Système de circuit selon la revendication 1, dans lequel le matériau ferromagnétique (301, 307, 311) est un noyau ferromagnétique toroïdal (301) et dans lequel le conducteur (303) comprend une pluralité de bobinages autour du noyau ferromagnétique toroïdal (301).

4. Système de circuit selon la revendication 1, dans lequel le matériau ferromagnétique (307, 313) entoure au moins une partie du conducteur (305, 311).

5. Système de circuit selon la revendication 1, dans lequel le conducteur (311) est une ligne en ruban formée sur un substrat (309), et dans lequel le matériau ferromagnétique (313) entoure au moins une partie de la ligne en ruban (311).

6. Système de circuit selon l'une quelconque des revendications 1 à 5, dans lequel le moyen (111) est fonctionnel pour générer un premier courant DC passant dans le conducteur (303, 305, 311) en vue de saturer le matériau ferromagnétique (301, 307, 313), pour amener l'interrupteur magnétique (109 ; 427, 441) dans le premier état de saturation.

7. Système de circuit selon la revendication 6, dans lequel le moyen (111) pour placer comprend une source de courant DC connectée aux conducteurs (303, 305, 311) par un interrupteur (421, 433) présentant un premier état de commutation et un deuxième état de commutation, et dans lequel le moyen (111) est opérationnel pour amener l'interrupteur (421, 433) dans le premier état de commutation, pour connecter les conducteurs (303, 305, 311) à la source de courant DC, afin de générer le premier courant DC, ou pour amener l'interrupteur dans le deuxième état de commutation, pour déconnecter le connecteur (303, 305, 311) de la source de courant DC.

8. Système de circuit selon la revendication 7, dans lequel le moyen (111) pour placer est intégré dans le module de circuit (415, 429), de sorte que l'interrupteur (421, 433) soit couplé au conducteur (303, 305, 311) par le sous-bus (425, 439).

9. Système de circuit selon la revendication 8, dans lequel la source de courant DC comprend une résistance de terminaison (417, 435) couplée entre l'interrupteur (412, 433) et une fiche de connexion (419, 437), et dans lequel la fiche de connexion (419, 437) est adaptée pour l'application d'une tension DC, pour générer un courant DC.

10. Système de circuit selon l'une quelconque des revendications 1 à 9, dans lequel le système de circuit comprend, par ailleurs, un contrôleur de mémoire (413) opérationnel pour fournir un signal d'information au bus principal (101 ; 401), pour mémoriser l'information dans le module de circuit (105 ; 415, 429) lorsque l'interrupteur magnétique saturable (109 ; 427, 441) est dans le premier état de saturation.

11. Système de circuit selon les revendications 9 ou 10, dans lequel le module de circuit (105 ; 415, 429) comprend un autre interrupteur (503) couplé en parallèle à la résistance (417), l'interrupteur étant opérationnel pour ponter ou ne pas ponter la résistance (417), pour moduler un courant sur le bus principal (401) selon une information mémorisée dans le module de circuit (415).

12. Procédé pour coupler un module de circuit à, ou pour découpler celui-ci d'un bus principal (101 ; 401), le module de circuit étant couplé à un sous-bus, le sous-bus étant couplé au bus principal par un interrupteur magnétique saturable (109), l'interrupteur magnétique saturable (109) comprenant un conducteur connecté entre le sous-bus et le bus principal et un matériau ferromagnétique saturable par un courant DC passant dans le conducteur, l'interrupteur magnétique présentant une première inductance dans un premier état de saturation et une deuxième inductance dans un deuxième état de saturation, la première inductance étant plus basse que la deuxième inductance, le procédé comprenant les étapes consistant à :
placer l'interrupteur magnétique saturable (109) dans le premier état de saturation, pour coupler le sous-bus (107) au bus principal (101), ou
placer l'interrupteur magnétique saturable (109) dans le deuxième état de saturation, pour découpler le sous-bus (107) du bus principal (101; 401).
